# EUROPEAN PATENT APPLICATION

(11) **EP 4 517 458 A1**
(43) Date of publication of application: **05.03.2025**
(21) Application number: 23194184.0
(22) Date of filing: 30.08.2023
(51) Int. Cl.: G05B 19/418, G06F 30/20, G06N 5/02, G06N 20/00

(54) **METHOD AND SYSTEM FOR MONITORING MODIFICATION IN HARDWARE CONFIGURATION OF PLURALITY OF HARDWARE EQUIPMENTS**

(71) Applicant: Siemens Aktiengesellschaft, 80333 München (DE)
(72) Inventor: Thiagarajan, Sezhiyan, 560102 Bangalore, Karnataka (IN)
(74) Representative: Isarpatent

(57) **Abstract**

The present invention provides a method and system for monitoring modifications of a hardware configuration of a plurality of hardware equipment in an industrial plant (106). The method further comprises generating a second named graph (514) based on an analysis of the one or more modifications (502B) of the hardware configuration of the plurality of hardware equipment. The method further comprises determining a reconstruction loss parameter by application of an autoen-coder algorithm on the second named graph (508). The method further comprises determining that the one or more modifications of the hardware configuration is invalid based on a comparison of the reconstruction loss parameter with the reconstruction loss parameter threshold. The method further comprises outputting a user alert based on the determination that the one or more modifications are invalid.

## Description

The present invention relates to a field of computer assisted programming, and more particularly relates to a method and system for monitoring modification in hardware configuration of plurality of hardware equipment.

Typically, a industrial plant comprises a plurality of hardware equipment. Examples of the plurality of hardware equipment comprises motors, robots, logical controllers, human machine interfaces, conveyor belts, and machine lathes. Deployment of the plurality of hardware equipment, into the industrial plant, requires expertise of professionals from a plurality of engineering disciplines. For example, in order to configure a hardware configuration associated with a hardware equipment, an expertise of a hardware engineer is required. Similarly, to code a plurality of engineering objects (such as a program file, an openness file, an automation markup language (AML) file, a memory object) configured to automate the plurality of hardware equipment, an expertise of an automation engineer is required. Thus the hardware engineer and the automation engineer are required to work in cooperation with each other, in order to deploy and automate the plurality of hardware equipment in the industrial plant. Thus, it is vital to have a healthy exchange of technical information (about the industrial plant) between the hardware engineer and the automation engineer. However, the automation engineer may find it difficult to understand technical information provided by the hardware engineer, especially when the technical information is provided in a data format which is unfamiliar to the automation engineer.

Thus, the technical information about the plurality of hardware equipment is exchanged between the hardware and automation engineer, by use of a commonly agreed upon format such as an automation markup language (AML). In one example, the commonly agreed upon format is an information exchange format defined between an electrical engineering application and an automation engineering application. In such a case, the hardware engineer may have to manually code the technical information associated with the plurality of hardware equipment, into an exchange data file. The exchange data file is then imported and used by the automation engineer to generate the plurality of engineering objects.

Typically, the industrial plant may have thousands of hardware equipment, each with a specific hardware configuration. Since the hardware configuration of each of the thousands of hardware equipment may have to be coded into the exchange data file. Thus, the hardware engineer may have to manually code thousands of lines of code to exchange the technical information with the automation engineer.

In one use case, the hardware configuration of the industrial plant is modified by the hardware engineer after import of the exchange data file by the automation engineer. In such a case, the hardware engineer has to manually validate if one or more modifications made by the hardware engineer are valid. The automation engineer may find it extremely difficult to validate the one or more modifications of the plurality of hardware equipment in light of maintaining the integrity of the engineering project.

Furthermore, the exchange data file fails to provide IT (information technology) tools which would enable an IT engineer to integrate OT (Operation technology) data with IT use cases.

Thus, it is laboursome to ensure exchange of technical information between professionals of diverse engineering disciplines, and thereby ensure a smooth generation of the engineering project.

In light of above, there exists a need for an efficient method and system for monitoring modifications of hardware configuration of a plurality of hardware equipments in an industrial plant.

Therefore, it is an object of the present invention to provide a method and system for monitoring modifications of a hardware configuration of a plurality of hardware equipment in an industrial plant.

The object of the invention is achieved by a method for monitoring modifications of a hardware configuration of a plurality of hardware equipment in the industrial plant. The industrial plant is at least one of a manufacturing plant, a energy production plant or a recycling plant. The industrial plant comprises the plurality of hardware equipment which are configured to achieve a specific objective in the industrial plant. Examples of the objective comprises at least an objective to manufacture a product in the industrial plant. Examples of the plurality of hardware equipment comprises motors, robots, logical controllers, human machine interfaces, conveyor belts, and machine lathes.

The method comprises receiving, by the processing unit, a plurality of engineering projects from a database. The plurality of engineering projects comprises the plurality of hardware equipments and a plurality of engineering objects. Each engineering project of the plurality of engineering projects comprises information associated with a hardware configuration of each piece of hardware equipment of the plurality of hardware equipment. In one example, the information about the hardware configuration, is coded as a plurality of automation markup language scripts. The plurality of automation markup language scripts comprises information associated with a plurality of interconnections and electrical connections between the plurality of hardware equipments in the plurality of engineering projects. The hardware configuration, of the plurality of engineering projects, comprises a power rating, a voltage rating, a durability, a strength, a electrical component configurations, symbol definitions, voltage and wiring aspects, associated with the plurality of hardware equipment in the plurality of engineering projects. The hardware configuration further comprises information about interconnections between the plurality of hardware equipments in the plurality of engineering projects.

In one example, the hardware configuration of the plurality of hardware equipment is encoded in the plurality of automation markup language scripts in a hierarchical structure. The plurality of automation markup language scripts further comprises information about interrelationships between the plurality of hardware equipment and the plurality of engineering objects of the plurality of engineering projects. The plurality of engineering objects comprises software objects such as a program file, an openness file, an programming block, or a memory object.

In a preferred embodiment, the method further comprises analyzing, by the processing unit, the plurality of automation markup language scripts to detect a plurality of nodes in the plurality of automation markup language scripts. In one example, the plurality of automation markup language scripts are analyzed by application of a parsing algorithm on the plurality of automation markup language scripts. Each node of the plurality of nodes are indicative of a fundamental unit of each of the plurality of automation markup language scripts.

The method further comprises converting, by the processing unit, each of the plurality of nodes to one or more knowledge graph triples. Thus, the hierarchical relationships within each of the plurality of automation markup language scripts is converted into a semantic representation of the one or more knowledge graph triples. Each of the plurality of nodes are converted into the one or more knowledge triples by application of at least one of a graph algorithm, a natural language processing algorithm, or an ontology mapping algorithm on the node.

The method further comprises generating, by the processing unit, a first set of named graphs from the one or more knowledge graph triples. The first set of named graphs comprises knowledge graph based semantic representations of hierarchical relationships between each of the plurality of nodes in each of the plurality of automation markup language scripts. In other words, the method comprises generating, by the processing unit, the first set of named graphs based on the analysis of the hardware configuration of the plurality of hardware equipment and the plurality of engineering objects in the plurality of engineering projects.

In the preferred embodiment, the method further comprises encoding, by the processing unit, the first set of named graphs to generate a first set of encoded data items by application of the autoencoder algorithm on the first set of named graphs. In one example, the autoencoder algorithm is an artificial intelligence model based autoencoder algorithm. Examples of the autoencoder algorithm include, but is not limited to a Graph Convolutional Networks (GCNs), Graph Attention Networks (GAT), a GraphSAGE, a Graph Isomorphism Networks (GIN), Transformer-based model, a GPT (Generative Pre-trained Transformer and a Graph Neural Network (GNN). In one example, the first set of encoded data items comprises named graphs comprising one or more entity embeddings which comprises information of the first set of named graphs in an encoded format. Examples of the first set of encoded data items comprises at least one of a token embedding and a node embedding. The autoencoder algorithm is configured to encode the first set of named graphs to the first set of encoded data items. The autoencoder algorithm is further configured to decode the first set of encoded data items to generate a second set of named graphs.

In the preferred embodiment, the method further comprises decoding the first set of encoded data items to generate the second set of named graph by application of the autoencoder algorithm on the first set of encoded data items. The method further comprises comparing each named graph of the first set of named graph with a specific named graph of the second set of named graph. In one example, the first set of named graphs are compared with the second set of named graph by application of a comparison algorithm on the first and the second set of named graphs. Examples of the comparison algorithms include but is not limited to a Mean Squared Error (MSE) algorithm, a Binary Cross-Entropy (BCE) algorithm, Categorical Cross-Entropy based algorithm, Perceptual Loss based algorithm, and Structural Similarity Index (SSIM) based algorithm.

In the preferred embodiment, the method further comprises determining a plurality of reconstruction loss parameters based on the comparison. Each of the plurality of reconstruction loss parameters is indicative of a degree of differences between the first set of named graphs and the second set of named graphs. Examples of each of the plurality of reconstruction loss parameters includes a mean squared loss error, a binary cross-entropy loss, and a categorical cross-entropy loss. In one example, the method further comprises assigning at least one reconstruction loss parameter, of the plurality of reconstruction loss parameters, as a reconstruction loss parameter threshold. In another example, the reconstruction loss parameter threshold is determined by application of a mathematical algorithm such as an averaging algorithm on the plurality of reconstruction loss parameters. For example, the reconstruction loss parameter threshold is an average value of the plurality of reconstruction loss parameters. In other words, the method comprises determining the reconstruction loss parameter threshold by application of the autoencoder algorithm on the first set of named graphs.

In a preferred embodiment, information associated with a hardware configuration of a set of hardware equipment and a set of engineering objects in an engineering project is coded as a first automation markup language script or the like. The first automation markup language script comprises information associated with a plurality of interconnections and electrical connections between the set of hardware equipments in the engineering project. In one example, the hardware configuration is converted into the first automation markup language script by the processing unit.

In a preferred embodiment, the first automation markup language script is encoded in an exchange data file used to exchange technical information between a hardware engineer and an automation engineer. The hardware configuration is encoded in the first automation markup language script in a hierarchical structure. The first automation markup language script comprises information about interrelationships between the set of hardware equipment and a set of engineering objects of the engineering project. The set of engineering objects comprises software objects such as a program file, an openness file, an programming block, or a memory object. The engineering project is an existing engineering project configured to control and automate the plurality of hardware equipment in the industrial plant. In one example, the engineering project is configured to automate the plurality of hardware equipment in the industrial plant. The set of engineering objects are executed by one or more controllers in the industrial plant to automate the plurality of hardware equipment in the industrial plant.

In a preferred embodiment, the method further comprises analyzing, by the processing unit, the first automation markup language script to detect a plurality of nodes in the first automation markup language script. The plurality of nodes are detected by application of a parsing algorithm on the first automation markup language script. Each of the plurality of nodes are basic building blocks of the first automation markup language script.

The method further comprises converting, by the processing unit, each of the plurality of nodes to one or more knowledge graph triples. Thus, hierarchical relationships within the first automation markup language script is converted into a semantic representation of the one or more knowledge graph triples. The method further comprises generating, by the processing unit, a first named graph from the one or more knowledge graph triples. The first named graph comprises a knowledge graph based semantic representation of hierarchical relationships between each of the plurality of nodes in the first automation markup language script. In other words, the method comprises generating, by the processing unit, the first named graph based on the analysis of the hardware configuration of the set of hardware equipment and the set of engineering objects in the engineering project. The first named graph comprises information about relationships between the hardware configuration of the set of hardware equipment and the set of engineering objects associated with the engineering project.

The method further comprises receiving from a user, by the processing unit, information about one or more modifications in the hardware configuration of the set of hardware equipment in the engineering project. In one example, the user may use an electrical designer application to modify the hardware configuration of the set of hardware equipment. In another example, the set of hardware equipments are rearranged by the user. In yet another example, the user rewires interconnections between the set of hardware equipments to modify the hardware configuration of the set of hardware equipments. The processing unit is configured to code the one or more modifications, of the hardware configuration, as a second automation markup language script. The second automation markup language script comprises information about hierarchical relationships between the set of hardware equipment, after the modification of the hardware configuration of the set of hardware equipment.

In the prefered embodiment, the method further comprises analyzing, by the processing unit, the first named graph, and the one or more modifications in the hardware configuration of the set of hardware equipment. The method further comprises generating, by the processing unit, a second named graph based on the analysis of the one or more modifications of the hardware configuration of the set of hardware equipment. The second named graph comprises information about relationships between a modified hardware configuration of the set of hardware equipment and the plurality of engineering objects.

The method further comprises determining, by the processing unit, a first hierarchical path between at least two nodes of the first named graph, and a second hierarchical path between corresponding nodes of the second named graph. The method further comprises comparing, by the processing unit, the determined first hierarchical path and the second hierarchical path.

In a preferred embodiment, the method further comprises determining, by the processing unit, the plurality of differences between the first named graph and the second named graph, based on the comparison. In one example, the plurality of differences are determined by the processing unit by use of a knowledge graph query process. The method further comprises mapping, by the processing unit, the determined plurality of differences to one or more engineering objects of the plurality of engineering objects. The method further comprises modifying, by the processing unit, the one or more engineering objects of the plurality of engineering objects of the engineering project. The one or more engineering objects are modified based on the second named graph. The method further comprises generating, by the processing unit, the engineering project from the plurality of engineering objects which comprises the one or more modified engineering objects.

In the preferred embodiment, the method further comprises encoding, by the processing unit, the second named graph to generate a second encoded data item by application of the autoencoder algorithm on the third named graph. In one example, the second encoded data item is a named graph comprising one or more entity embeddings which comprises information of the second named graph in an encoded format. Examples of the second encoded data items comprises at least one of a token embedding and a node embedding. The autoencoder algorithm is configured to encode the second named graph to the second encoded data item. The autoencoder algorithm is further configured to decode the second encoded data item to generate a third named graph.

In the preferred embodiment, the method further comprises decoding the second encoded data item to generate the third named graph by application of the autoencoder algorithm on the second encoded data item. The method further comprises comparing the third named graph with the second named graph. In one example, the third named graph is compared with the second named graph by application of a comparison algorithm such as a Mean Squared Error (MSE) algorithm, a Binary Cross-Entropy (BCE) algorithm, Categorical Cross-Entropy based algorithm, Perceptual Loss based algorithm, and Structural Similarity Index (SSIM) based algorithm on the second and the third named graph.

In the preferred embodiment, the method further comprises determining a reconstruction loss parameter based on the comparison. The reconstruction loss parameter is indicative of a degree of differences between the third named graph and the second named graph. Examples of the reconstruction loss parameter includes a mean squared loss error, a binary cross-entropy loss, and a categorical cross-entropy loss. In other words, the method comprises determining the reconstruction loss parameter by application of the autoencoder algorithm on the second named graph.

The method further comprises comparing, by the processing unit, the reconstruction loss parameter with the reconstruction loss parameter threshold. In a case where the reconstruction loss parameter is greater than the reconstruction loss parameter threshold, then the processing unit is configured to determine that the one or more modifications, to the hardware configurations, is invalid. In a case where the reconstruction loss parameter is lesser than the reconstruction loss parameter threshold, then the processing unit is configured to determine that the one or more modifications, to the hardware configurations, is valid. In other words, the method further comprises determining, by the processing unit, that the one or more modifications are invalid based on the comparison of the reconstruction loss parameter with the reconstruction loss parameter threshold. Advantageously, the reconstruction loss parameters is used to determine a validity of the one or more modifications in the hardware configurations. In a case where the reconstruction loss parameters is consistently high, the one or more modifications could be noisy, corrupted, or poorly represented in the training data. Thus, the processing unit is configured to detect noisy and corrupted data from the one or more modifications.

In the preferred embodiment, the method further comprises generating, by the processing unit, a user alert based on the determination that the one or more modifications are invalid. In the preferred embodiment, the method further comprises outputting, by the processing unit, the generated user alert. Advantageously, the user is informed on whether the one or more modifications are valid in light of one or more interrelationships between the set of engineering objects and the set of hardware equipments in the engineering project.

In a preferred embodiment, the method further comprises analyzing, by the processing unit, the second named graph to generate one or more recommendations for modification of the engineering project. The method further comprises displaying, by the processing unit, the one or more recommendations to one or more users.

In one example, the method further comprises applying a natural language processing algorithm on the generated one or more recommendations to generate a voice based recommendation to modify the engineering project.

In a preferred embodiment, the method comprises generating, by the processing unit, a simulation instance for an industrial environment. The method further comprises simulating, by the processing unit, deployment of the generated engineering project in the industrial environment by executing one or more functionalities of the engineering project on the generated simulation instance.

In a preferred embodiment, the method further comprises determining, by the processing unit, whether the generated engineering project is valid, based on a result of the simulated execution of the generated engineering project. The method further comprises deploying, by the processing unit, the engineering project in real-time onto the industrial environment, based on a determination that the generated engineering project is valid. The method further comprises displaying, by the processing unit, the engineering project on one of a display device.

The object of the present invention is also achieved by an engineering system for generating an engineering project in the industrial plant. The engineering system comprises one or more processing unit(s) and a memory coupled to the processing unit. The memory comprises an automation module stored in the form of machine-readable instructions executable by the processing unit. The automation module is configured for performing the method as described above.

The object of the present invention is also achieved by an industrial environment. The industrial environment comprising an engineering system, a industrial plant comprising one or more physical components and one or more client devices communicatively coupled to the engineering system and the industrial plant. The engineering system is configured to perform the above described method steps.

The object of the present invention is also achieved by a computer-program product having machine-readable instructions stored therein, that when executed by one or more processing unit(s), cause the one or more processing unit(s) to perform method steps as described above.

The above-mentioned and other features of the invention will now be addressed with reference to the accompanying drawings of the present invention. The illustrated embodiments are intended to illustrate, but not limit the invention.

The present invention is further described hereinafter with reference to illustrated embodiments shown in the accompanying drawings, in which:
- FIG 1: is a block diagram of an industrial environment capable of monitoring modifications of a hardware configuration of a plurality of hardware equipment in an industrial plant, according to an embodiment of the present invention;
- FIG 2: is a block diagram of an engineering system, such as those shown in FIG. 1, in which an embodiment of the present invention can be implemented;
- FIG 3: is a block diagram of an automation module, such as those shown in FIG 2, in which an embodiment of the present invention can be implemented;
- FIG 4A-D: is a process flowchart illustrating an exemplary method of monitoring modifications of a hardware configuration of a plurality of hardware equipment in an industrial plant, according to an embodiment of the present invention; and
- FIG 5: is a process flow diagram illustrating an exemplary method of monitoring modifications of a hardware configuration of a plurality of hardware equipment in an industrial plant, according to an embodiment of the present invention.
Various embodiments are described with reference to the drawings, wherein like reference numerals are used to refer the drawings, wherein like reference numerals are used to refer to like elements throughout. In the following description, for the purpose of explanation, numerous specific details are set forth in order to provide thorough understanding of one or more embodiments. It may be evident that such embodiments may be practiced without these specific details.

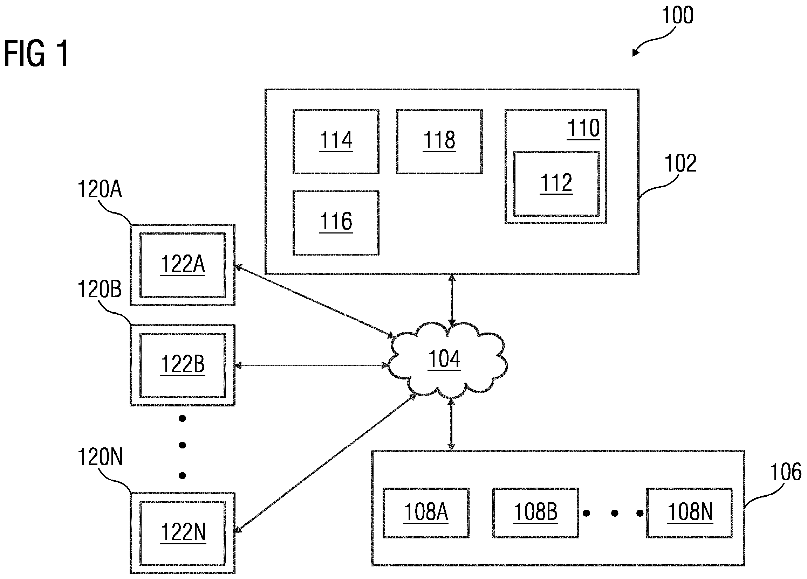

FIG 1 is a block diagram of an industrial environment 100 capable of monitoring modifications of a hardware configuration of a plurality of hardware equipment in an industrial plant 106, according to an embodiment of the present invention. In FIG 1, the industrial environment 100 includes an engineering system 102 which can be controlled with a plurality of engineering projects and one or more client devices 120A-N. As used herein, "industrial environment" refers to a processing environment comprising configurable computing physical and logical resources, for example, networks, servers, storage, applications, services, etc., and data distributed over a platform, such as cloud computing platform. The plurality of engineering projects is a collection of programs, software configurations, hardware configurations, and wiring related documents which enable an automation of a plurality of hardware equipments of the industrial plant 106. Examples of the plurality of hardware equipment 108A0N comprises servers, robots, switches, automation devices, programmable logic controllers (PLC)s, human machine interfaces (HMIs), motors, valves, pumps, actuators, sensors and other hardware equipment (s). The industrial environment 100 provides on-demand network access to a shared pool of the configurable computing physical and logical resources. The engineering system 102 is communicatively connected to the plurality of hardware equipments of the industrial plant 106 via the network 104 (such as Local Area Network (LAN), Wide Area Network (WAN), Wi-Fi, Internet, any short range or wide range communication). The engineering system 102 is also connected to the one or more client devices 120A-N via the network 104.

The plurality of engineering projects comprises a plurality of engineering objects. Each of the plurality of engineering objects comprises design information and source code associated with a specific aspect or a specific industrial process of the plurality of hardware equipment 108A-N of the industrial plant 106. Examples of the plurality of engineering objects comprises a design file, a program logic controller block, a tag table, an alarm object, a plant automation object, a program file, an openness file, an automation markup language (AML) file, a memory object, and and a piping and instrumentation diagram of the industrial plant 106. Each of the plurality of engineering objects may have a different specification of a plurality of specifications. A specification of an engineering object defines a purpose of the engineering object. The specification comprises coding languages, coding conventions, software configurations, processing speed restrictions, memory restrictions, and key process indicators associated with the engineering object. Each of the one or more engineering objects comprises information and source code required to control a specific hardware equipment in the plurality of hardware equipments of the industrial plant 106.

The plurality of engineering objects may further include source code associated with hardware configurations of each of the plurality of hardware equipments of the industrial plant 106. The plurality of hardware equipments may be connected to each other or several other components (not shown in FIG 1) via physical connections. The physical connections may be through wiring between the plurality of hardware equipments. Alternatively, the plurality of hardware equipments may also be connected via non-physical connections (such as Internet of Things (IOT)) and 5G networks. Although, FIG 1 illustrates the engineering system 102 connected to the plurality of hardware equipments. One skilled in the art can envision that the engineering project may be stored in a memory storage device of the engineering system 102 or be stored in one or more servers located at different geographical locations.

The client devices 120A-N may be a desktop computer, laptop computer, tablet, smart phone and the like. Each of the client devices 120A-N is provided with an engineering tool 122AN for generating and/or editing a plurality of engineering projects respectively. The plurality of engineering projects comprises engineering projects which are designed for controlling the industrial plant 106. Examples of the industrial plant 106 includes but is not limited to manufacturing plants, power plants, and recycling plants.

The client devices 120A-N can access the engineering system 102 for modifying one or more engineering projects of the plurality of engineering projects. The client devices 120A-N can access cloud applications (such as providing performance visualization of the one or more engineering objects via a web browser). Throughout the specification, the terms "client device" and "user device" are used interchangeably.

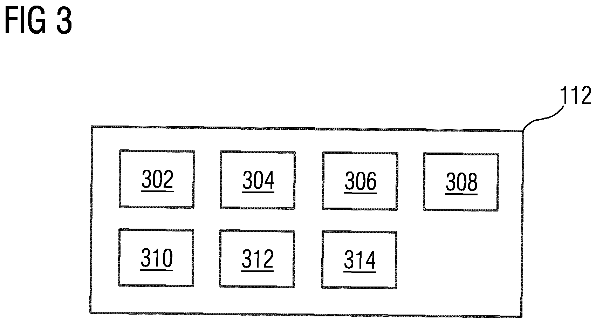

The engineering system 102 may be a standalone server deployed at a control station or may be a remote server on a cloud computing platform. In a preferred embodiment, the engineering system 102 may be a cloud-based engineering system. The engineering system 102 is capable of delivering applications (such as cloud applications) for managing the engineering project comprising the one or more engineering objects. The engineering system 102 may comprise a platform 110(such as a cloud computing platform), an automation module 112, a server 114 including hardware resources and an operating system (OS), a network interface 116 and a database 118. The network interface 116 enables communication between the engineering system 102 and the client device(s) 120A-N. The interface (such as cloud interface)(not shown in FIG 1) may allow the engineers at the one or more client device(s) 120A-N to access a plurality of engineering project files stored at the engineering system 102 and perform one or more actions on the plurality of engineering project files as same instance. The server 114 may include one or more servers on which the OS is installed. The servers 114 may comprise one or more processing units, one or more storage devices, such as, memory units, for storing data and machine-readable instructions for example, applications and application programming interfaces (APIs), and other peripherals required for providing computing (such as cloud computing) functionality. The platform 110 enables functionalities such as data reception, data processing, data rendering, data communication, etc. using the hardware resources and the OS of the servers 114 and delivers the aforementioned services using the application programming interfaces deployed therein. The platform 110 may comprise a combination of dedicated hardware and software built on top of the hardware and the OS. In an exemplary embodiment, the platform 110 may correspond to an Integrated Development Environment (IDE) comprising program editors and compilers which allow the users of the client devices 120A-N to modify the plurality of engineering projects. The platform 110 may further comprise an automation module 112 configured for generating engineering projects. Details of the automation module 112 is explained in FIG. 3.

The database 118 stores the information relating to the plurality of engineering projects and the client device(s) 120AN. The database 118 is, for example, a SPARQL, a structured query language (SQL) data store or a not only SQL (NoSQL) data store. In an exemplary embodiment, the database 118 may be configured as cloud-based database implemented in the industrial environment 100, where computing resources are delivered as a service over the platform 110. The database 118, according to another embodiment of the present invention, is a location on a file system directly accessible by the automation module 112. The database 118 is configured to store engineering project files, engineering projects, object behavior model, parameter values associated with the one or more engineering objects, test results, simulation results, status messages, one or more simulation instances, graphical programs, program logics, program logic patterns, the one or more engineering objects and engineering object properties, one or more engineering object blocks, relationship information between the one or more engineering objects, requirements, program update messages and the like.

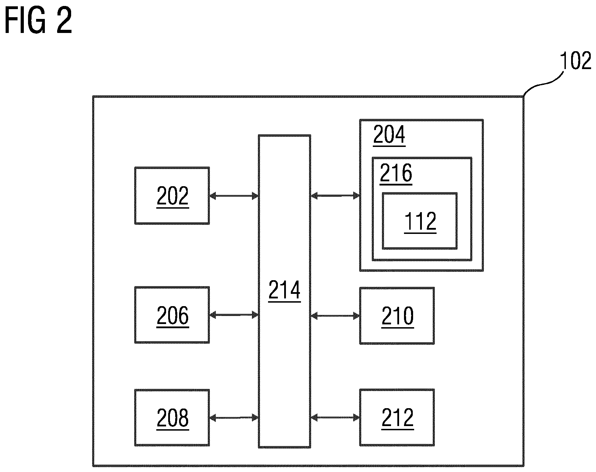

FIG 2 is a block diagram of an engineering system 102, such as those shown in FIG 1, in which an embodiment of the present invention can be implemented. In FIG 2, the engineering system 102 includes a processing unit 202, an accessible memory 204, a storage unit 206, a communication interface 208, an input-output unit 210, a network interface 212 and a bus 214.

The processing unit 202, as used herein, means any type of computational circuit, such as, but not limited to, a micro processing unit unit, microcontroller, complex instruction set computing micro processing unit unit, reduced instruction set computing micro processing unit unit, very long instruction word micro processing unit unit, explicitly parallel instruction computing micro processing unit unit, graphics processing unit, digital signal processing unit, or any other type of processing circuit. The processing unit 202 may also include embedded controllers, such as generic or programmable logic devices or arrays, application specific integrated circuits, single-chip computers, and the like.

The memory 204 may be non-transitory volatile memory and nonvolatile memory. The memory 204 may be coupled for communication with the processing unit 202, such as being a computer-readable storage medium. The processing unit 202 may execute machine-readable instructions and/or source code stored in the memory 204. A variety of machine-readable instructions may be stored in and accessed from the memory 204. The memory 204 may include any suitable elements for storing data and machine-readable instructions, such as read only memory, random access memory, erasable programmable read only memory, electrically erasable programmable read only memory, a hard drive, a removable media drive for handling compact disks, digital video disks, diskettes, magnetic tape cartridges, memory cards, and the like. In the present embodiment, the memory 204 includes an integrated development environment (IDE) 216. The IDE 216 includes an automation module 112 stored in the form of machine-readable instructions on any of the above-mentioned storage media and may be in communication with and executed by the processing unit 202. In one example, the engineering project may be stored inside the memory 204.

The storage unit 206 may be a non-transitory storage medium configured for storing a database (such as database 118) which comprises server version of the one or more engineering object 108A-N associated with the engineering project.

The communication interface 208 is configured for establishing communication sessions between the one or more client devices 120A-N and the engineering system 102. The communication interface 208 allows the one or more engineering applications running on the client devices 120A-N to import/export engineering project files into the engineering system 102. In an embodiment, the communication interface 208 interacts with the interface at the one or more client devices 120A-N for allowing the engineers to access the engineering projects associated with an engineering project file and perform one or more actions on the engineering projects stored in the engineering system 102.

The input-output unit 210 may include input devices a keypad, touch-sensitive display, camera (such as a camera receiving gesture-based inputs), etc. capable of receiving one or more input signals, such as user commands to process engineering project file. Also, the input-output unit 210 may be a display unit for displaying a graphical user interface which visualizes the behavior model associated with the modified engineering projects and also displays the status information associated with each set of actions performed on the graphical user interface. The set of actions may include execution of predefined tests, download, compile and deploy of graphical programs. The bus 214 acts as interconnect between the processing unit 202, the memory 204, and the input-output unit 210.

The network interface 212 may be configured to handle network connectivity, bandwidth and network traffic between the engineering system 102, client devices 120A-N and the engineering project.

Those of ordinary skilled in the art will appreciate that the hardware depicted in FIG 2 may vary for particular implementations. For example, other peripheral devices such as an optical disk drive and the like, Local Area Network (LAN), Wide Area Network (WAN), Wireless (e.g., Wi-Fi) adapter, graphics adapter, disk controller, input/output (I/O) adapter also may be used in addition or in place of the hardware depicted. The depicted example is provided for the purpose of explanation only and is not meant to imply architectural limitations with respect to the present disclosure.

Those skilled in the art will recognize that, for simplicity and clarity, the full structure and operation of all data processing systems suitable for use with the present disclosure is not being depicted or described herein. Instead, only so much of an engineering system 102 as is unique to the present disclosure or necessary for an understanding of the present disclosure is depicted and described. The remainder of the construction and operation of the engineering system 102 may conform to any of the various current implementation and practices known in the art.

FIG 3 is a block diagram of an automation module 112, such as those shown in FIG 2, in which an embodiment of the present invention can be implemented. In FIG 3, the automation module 112 comprises a request handler module 302, a ontology generator module 304, an analysis module 306, a modifier module 308, an engineering project database 310, a validation module 312 and a deployment module 314. FIG. 3 is explained in conjunction with FIG. 1 and FIG. 2.

The request handler module 302 is configured for receiving the request to modify one or more of the plurality of engineering projects. For example, the request is received from one of the one or more users external to the industrial environment 100 via a network. In alternative embodiment, the request is received from the one or the one or more client devices 120A-N via the network.

The ontology generator module 304 is configured for generating a first named graph from a hardware configuration file associated with a set of hardware equipment 108A-N of an engineering project. In an embodiment, the ontology generator module 304 is configured to generate a knowledge graph from the hardware configuration file. The hardware configuration file is encoded as an automation markup language script. The ontology generator module 304 is configured to analyze the automation markup language script to detect a plurality of nodes in the first automation markup language script. The ontology generator module 304 is configured to convert each of the plurality of nodes to one or more knowledge graph triples. The ontology generator module 304 is configured to generate the first named graph from the one or more knowledge graph triples. The first named graph comprises a knowledge graph based semantic representation of hierarchical relationships between each of the plurality of nodes in the automation markup language script. In one example, the ontology generator module 304 is configured to analyze the automation markup language script by application of a natural language processing algorithm on the hardware configuration.

The analysis module 306 is configured for analyzing the named graph generated by the ontology generator module 304. Specifically, the analysis module 306 is configured for mapping a plurlaity of nodes of the first named graph to the plurality of hardware equipment 108A-N of the industrial plant 106. Furthermore, the analysis module 306 is configured for analyzing the behavior of the plurality of hardware equipment 108A-N based on the generated named graph. The analysis module 306 is further configured to apply an autoencoder algorithm on a plurality of named graphs to generate a plurality of reconstruction parameter losses.

The modifier module 308 is configured for modifying the one or more engineering objects based on the outcome of analysis of the first named graph. The one or more engineering objects is modified based on the analysis of the first named graph. The modifications comprise any changes such as addition, deletion, update, replacement or revision of one or more variables, code lines, classes, functions, or comments in the one or more engineering objects. Thus, the one or more engineering objects are modified based on the relationships between the set of variables corresponding to teh plurality of Key process indicators associated with the plurality of industrial processes and the engineering project. Thus, the plurality of engineering projects is generated based on the relationships between the set of variables corresponding to each logical block in the one or more engineering objects, the set of Key process indicators associated with the one or more engineering objects, and the industrial domain of the engineering project.

The engineering project database 310 is configured for storing an engineering project library comprising the plurality of engineering projects and the generated first named graph. The engineering project database 310 is configured for continuously updating the engineering project library with updated versions of the optimized engineering project. Also, the engineering project database 310 is configured for maintaining the engineering project library in the generated named graph.

The validation module 312 is configured to generate a simulation instance for the industrial environment 100. In one example, the simulation instance is a digital twin of the plurality of hardware equipment 108A-N which are functioning in the industrial plant 106 of the industrial environment 100. The validation module 312 is configured to simulate execution of the engineering project on the plurality of hardware equipment 108A-N in a simulation environment by executing the generated first engineering object on the generated simulation instance.

The deployment module 314 is configured for deploying the optimized engineering project onto the industrial environment 100 based on the validation. Advantageously, the optimized engineering project is only deployed after the determination that the optimized engineering project is valid.

When executed by processing unit 202, the automation module 112 causes the processing unit 202 to receive the plurality of engineering projects from the database 118. It is noted that the plurality of engineering projects comprises the plurality of hardware equipments and the plurality of engineering objects. Each engineering project of the plurality of engineering projects comprises information associated with a hardware configuration of each piece of hardware equipment of the plurality of hardware equipment. In one example, the information about the hardware configuration, is coded as a plurality of automation markup language scripts. The plurality of automation markup language scripts comprises information associated with a plurality of interconnections and electrical connections between the plurality of hardware equipments in the plurality of engineering projects. The hardware configuration, of the plurality of engineering projects, comprises a power rating, a voltage rating, a durability, a strength, a electrical component configurations, symbol definitions, voltage and wiring aspects, associated with the plurality of hardware equipment in the plurality of engineering projects. The hardware configuration further comprises information about interconnections between the plurality of hardware equipments in the plurality of engineering projects.

In one example, the hardware configuration of the plurality of hardware equipment is encoded in the plurality of automation markup language scripts in a hierarchical structure. The plurality of automation markup language scripts further comprises information about interrelationships between the plurality of hardware equipment and the plurality of engineering objects of the plurality of engineering projects. The plurality of engineering objects comprises software objects such as a program file, an openness file, an programming block, or a memory object.

The automation module 112 further causes the processing unit 202 to analyze the plurality of automation markup language scripts to detect a plurality of nodes in the plurality of automation markup language scripts. In one example, the plurality of automation markup language scripts are analyzed by application of a parsing algorithm on the plurality of automation markup language scripts. Each node of the plurality of nodes is indicative of a basic building unit of each of the plurality of automation markup language scripts. Each node of the plurality of nodes are elements of at least one of the plurality of automation markup language scripts. In one example, each node of the plurality of nodes comprises information associated with a specific equipment of the plurality of hardware equipments.

The automation module 112 further causes the processing unit 202 to convert each of the plurality of nodes to one or more knowledge graph triples. Thus, the hierarchical relationships within each of the plurality of automation markup language scripts is converted into a semantic representation of the one or more knowledge graph triples. Each of the plurality of nodes are converted into the one or more knowledge triples by application of at least one of a graph algorithm, a natural language processing algorithm, or an ontology mapping algorithm on the node.

The automation module 112 further causes the processing unit 202 to generate a first set of named graphs from the one or more knowledge graph triples. The first set of named graphs comprises knowledge graph based semantic representations of hierarchical relationships between each of the plurality of nodes in each of the plurality of automation markup language scripts. In other words, the method comprises generating, by the processing unit, the first set of named graphs based on the analysis of the hardware configuration of the plurality of hardware equipment and the plurality of engineering objects in the plurality of engineering projects.

The automation module 112 further causes the processing unit 202 to encode the first set of named graphs to generate a first set of encoded data items by application of the autoencoder algorithm on the first set of named graphs. In one example, the autoencoder algorithm is an artificial intelligence model based autoencoder algorithm. The autoencoder algorithm is stored in the database 118. Examples of the autoencoder algorithm include, but is not limited to a Graph Convolutional Networks (GCNs), Graph Attention Networks (GAT), a GraphSAGE, a Graph Isomorphism Networks (GIN), Transformer-based model, a GPT (Generative Pre-trained Transformer and a Graph Neural Network (GNN). In one example, the first set of encoded data items comprises one or more named graphs comprising one or more entity embeddings which comprises information of the first set of named graphs in an encoded format. Examples of the first set of encoded data items comprises at least one of a token embedding and a node embedding. The autoencoder algorithm is configured to encode the first set of named graphs to the first set of encoded data items. The autoencoder algorithm is further configured to decode the first set of encoded data items to generate a second set of named graphs.

The automation module 112 further causes the processing unit 202 to decode the first set of encoded data items to generate the second set of named graph by application of the autoencoder algorithm on the first set of encoded data items. The automation module 112 further causes the processing unit 202 to compare each named graph of the first set of named graph with a specific named graph of the second set of named graph. In one example, the first set of named graphs are compared with the second set of named graph by application of a comparison algorithm on the first and the second set of named graphs. Examples of the comparison algorithms include but is not limited to a Mean Squared Error (MSE) algorithm, a Binary Cross-Entropy (BCE) algorithm, Categorical Cross-Entropy based algorithm, Perceptual Loss based algorithm, and Structural Similarity Index (SSIM) based algorithm.

The automation module 112 further causes the processing unit 202 to determine a plurality of reconstruction loss parameters based on the comparison. Each of the plurality of reconstruction loss parameters is indicative of a degree of differences between the first set of named graphs and the second set of named graphs. Examples of each of the plurality of reconstruction loss parameters includes a mean squared loss error, a binary cross-entropy loss, and a categorical cross-entropy loss. In one example, the automation module 112 further causes the processing unit 202 to assign at least one reconstruction loss parameter, of the plurality of reconstruction loss parameters, as a reconstruction loss parameter threshold. In another example, the reconstruction loss parameter threshold is determined by application of a mathematical algorithm such as an averaging algorithm on the plurality of reconstruction loss parameters. For example, the reconstruction loss parameter threshold is an average value of the plurality of reconstruction loss parameters. In other words, the automation module 112 further causes the processing unit 202 to determine the reconstruction loss parameter threshold by application of the autoencoder algorithm on the first set of named graphs.

In one example, the processing unit 202 is configured to receive an engineering project from a user via the one or more client devices 120A-N. The engineering project comprises information associated with a set of hardware equipments 108A-N and a set of engineering objects of the engineering project. The engineering project further comprises information associated with a hardware configuration of the set of hardware equipment 108A-N. The information associated with the hardware configuration of the set of hardware equipment 108A-N and the set of engineering objects of the engineering project is coded as a first automation markup language script or the like. The first automation markup language script comprises information associated with a plurality of interconnections and electrical connections between the set of hardware equipments 108A-N in the engineering project. In one example, the hardware configuration is converted into the first automation markup language script by the processing unit 202.

The first automation markup language script is encoded in an exchange data file used to exchange technical information between a hardware engineer and an automation engineer. The hardware configuration is encoded in the first automation markup language script in a hierarchical structure. The first automation markup language script comprises information about interrelationships between the set of hardware equipment 108A-N and a set of engineering objects of the engineering project. The set of engineering objects comprises software objects such as a program file, an openness file, an programming block, or a memory object. The engineering project is an existing engineering project configured to control and automate the set of hardware equipment in the industrial plant.

In one example, the engineering project is configured to automate the set of hardware equipment 108A-N in the industrial plant 106. The set of engineering objects are executed by one or more controllers in the industrial plant 106 to automate the set of hardware equipment 108A-N in the industrial plant 106.

The automation module 112 further causes the processing unit 202 to analyze the first automation markup language script to detect a plurality of nodes in the first automation markup language script. The plurality of nodes are detected by application of a parsing algorithm on the first automation markup language script. Each of the plurality of nodes are basic building blocks of the first automation markup language script.

The automation module 112 further causes the processing unit 202 to convert each of the plurality of nodes to one or more knowledge graph triples. Thus, hierarchical relationships within the first automation markup language script is converted into a semantic representation of the one or more knowledge graph triples. The automation module 112 further causes the processing unit 202 to generate a first named graph from the one or more knowledge graph triples. The first named graph comprises a knowledge graph based semantic representation of hierarchical relationships between each of the plurality of nodes in the first automation markup language script. In other words, the automation module 112 further causes the processing unit 202 to generate the first named graph based on the analysis of the hardware configuration of the set of hardware equipment 108A-N and the set of engineering objects in the engineering project. The first named graph comprises information about relationships between the hardware configuration of the set of hardware equipment 108A-N and the set of engineering objects associated with the engineering project.

The automation module 112 further causes the processing unit 202 to receive information about one or more modifications in the hardware configuration of the set of hardware equipment 108A-N in the engineering project. In one example, the user may use an electrical designer application to modify the hardware configuration of the set of hardware equipment 108AN. In another example, the set of hardware equipments 108A-N are rearranged by the user. In yet another example, the user rewires interconnections between the set of hardware equipments 108A-N to modify the hardware configuration of the set of hardware equipment 108A-N. The processing unit 202 is configured to code the one or more modifications, of the hardware configuration, as a second automation markup language script. The second automation markup language script comprises information about hierarchical relationships between the set of hardware equipment 108A-N, after the modification of the hardware configuration of the set of hardware equipment 108A-N.

The automation module 112 further causes the processing unit 202 to analyze the first named graph, and the one or more modifications in the hardware configuration of the set of hardware equipment 108A-N. The automation module 112 further causes the processing unit 202 to generate a second named graph based on the analysis of the one or more modifications of the hardware configuration of the set of hardware equipment 108A-N. The second named graph comprises information about relationships between a modified hardware configuration of the set of hardware equipment 108A-N and the set of engineering objects.

The automation module 112 further causes the processing unit 202 to determine a first hierarchical path between at least two nodes of the first named graph, and a second hierarchical path between corresponding nodes of the second named graph. In one example, the first hierarchical path and the second hierarchical paths are determined by the processing unit 202 by application of a traversal algorithm on the first and the second named graph. Examples of the traversal algorithm include but is not limited to a Depth-First Search algortihm(DFS) and Breadth-First Search algorithm (BFS). The automation module 112 further causes the processing unit 202 to compare the determined first hierarchical path and the second hierarchical path.

The automation module 112 further causes the processing unit 202 to determine the plurality of differences between the first named graph and the second named graph, based on the comparison. In one example, the plurality of differences are determined by the processing unit by use of a knowledge graph query process. The automation module 112 further causes the processing unit 202 to map the determined plurality of differences to one or more engineering objects of the plurality of engineering objects. The automation module 112 further causes the processing unit 202 to modify the one or more engineering objects of the plurality of engineering objects of the engineering project. The one or more engineering objects are modified based on the second named graph. The automation module 112 further causes the processing unit 202 to generate the engineering project from the set of engineering objects 108A-N which comprises the one or more modified engineering objects.

The automation module 112 further causes the processing unit 202 to encode the second named graph to generate a second encoded data item by application of the autoencoder algorithm on the third named graph. In one example, the second encoded data item is a named graph comprising one or more entity embeddings which comprises information of the second named graph in an encoded format. Examples of the second encoded data item comprises at least one of a token embedding and a node embedding. The autoencoder algorithm is configured to encode the second named graph to the second encoded data item. The autoencoder algorithm is further configured to decode the second encoded data item to generate a third named graph.

The automation module 112 further causes the processing unit 202 to decode the second encoded data item to generate the third named graph by application of the autoencoder algorithm on the second encoded data item. The automation module 112 further causes the processing unit 202 to compare the third named graph with the second named graph. In one example, the third named graph is compared with the second named graph by application of a comparison algorithm such as a Mean Squared Error (MSE) algorithm, a Binary Cross-Entropy (BCE) algorithm, Categorical Cross-Entropy based algorithm, Perceptual Loss based algorithm, and Structural Similarity Index (SSIM) based algorithm on the second and the third named graph.

The automation module 112 further causes the processing unit 202 to determine a reconstruction loss parameter based on the comparison. The reconstruction loss parameter is indicative of a degree of differences between the third named graph and the second named graph. Examples of the reconstruction loss parameter includes a mean squared loss error, a binary cross-entropy loss, and a categorical cross-entropy loss. In other words, the automation module 112 further causes the processing unit 202 to determine the reconstruction loss parameter by application of the autoencoder algorithm on the second named graph.

The automation module 112 further causes the processing unit 202 to compare the reconstruction loss parameter with the reconstruction loss parameter threshold. In a case where the reconstruction loss parameter is greater than the reconstruction loss parameter threshold, then the processing unit 202 is configured to determine that the one or more modifications, to the hardware configuration, is invalid. In a case where the reconstruction loss parameter is lesser than the reconstruction loss parameter threshold, then the processing unit 202 is configured to determine that the one or more modifications, to the hardware configuration, is valid. In other words, the automation module 112 further causes the processing unit 202 to determine that the one or more modifications are invalid based on the comparison of the reconstruction loss parameter with the reconstruction loss parameter threshold.

The automation module 112 further causes the processing unit 202 to generate a user alert based on the determination that the one or more modifications are invalid. The automation module 112 further causes the processing unit 202 to output the generated user alert. Advantageously, the user is informed on whether the one or more modifications are valid in light of one or more interrelationships between the set of engineering objects and the set of hardware equipments in the engineering project.

In one example, the method further comprises applying a natural language processing algorithm on the generated user alret to generate a voice based recommendation about the one or more modifications of the hardware configuration of the set of hardware equipment 108A-N.

The automation module 112 further causes the processing unit 202 to generate a simulation instance for the industrial environment 100. The automation module 112 further causes the processing unit 202 to simulate deployment of the modified engineering project in the industrial environment 100 by executing one or more functionalities of the engineering project on the generated simulation instance.

The automation module 112 further causes the processing unit 202 to determine whether the one or more modifications are valid, based on a result of the simulated execution of the generated engineering project. The automation module 112 further causes the processing unit 202 to deploy the engineering project in real-time onto the industrial environment 100, based on a determination that the generated engineering project is valid. The method further comprises displaying, by the processing unit, the engineering project on a display device such as the one or more client devices 120A-N.

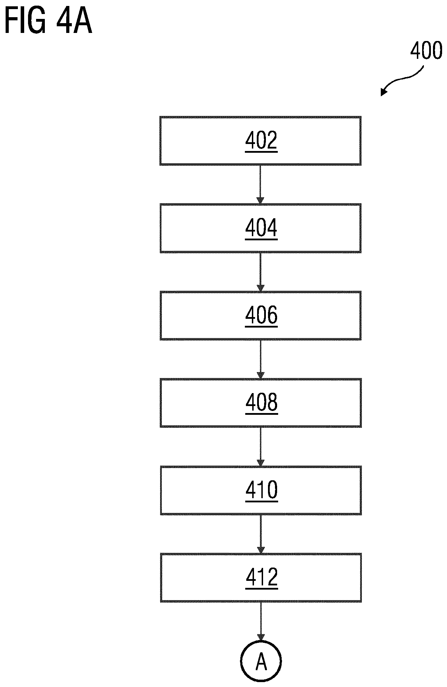

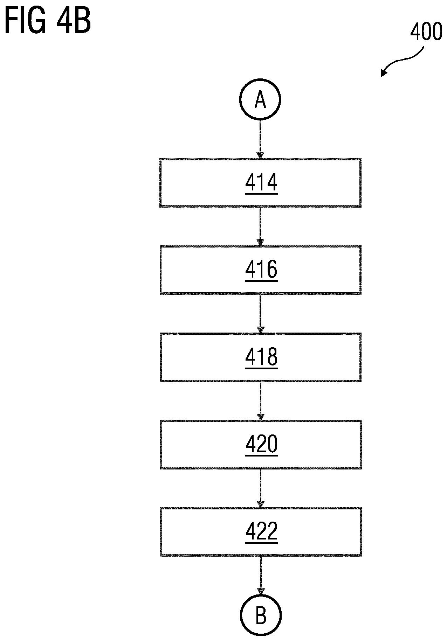

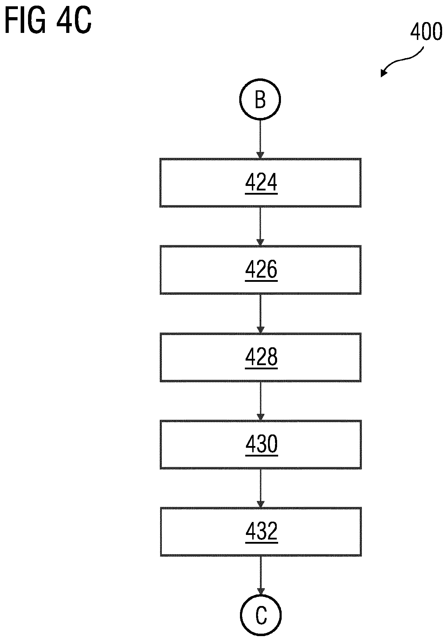

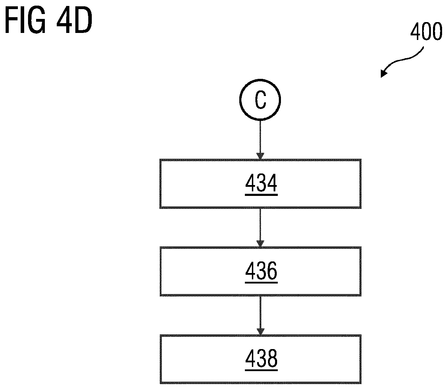

FIG 4A-D is a process flowchart illustrating an exemplary method of monitoring modifications of a hardware configuration of a plurality of hardware equipment in an industrial plant, according to an embodiment of the present invention.

At step 402, the automation module 112 causes the processing unit 202 to receive the plurality of engineering projects from the database 118. It is noted that the plurality of engineering projects comprises the plurality of hardware equipments and the plurality of engineering objects. Each engineering project of the plurality of engineering projects comprises information associated with a hardware configuration of each piece of hardware equipment of the plurality of hardware equipment. In one example, the information about the hardware configuration, is coded as a plurality of automation markup language scripts. The plurality of automation markup language scripts comprises information associated with a plurality of interconnections and electrical connections between the plurality of hardware equipments in the plurality of engineering projects.

In one example, the hardware configuration of the plurality of hardware equipment is encoded in the plurality of automation markup language scripts in a hierarchical structure. The plurality of automation markup language scripts further comprises information about interrelationships between the plurality of hardware equipment and the plurality of engineering objects of the plurality of engineering projects. The plurality of engineering objects comprises software objects such as a program file, an openness file, an programming block, or a memory object.

At step 404, the automation module 112 further causes the processing unit 202 to analyze the plurality of automation markup language scripts to detect a plurality of nodes in the plurality of automation markup language scripts. In one example, the plurality of automation markup language scripts are analyzed by application of a parsing algorithm on the plurality of automation markup language scripts.

At step 406, the automation module 112 causes the processing unit 202 to convert each of the plurality of nodes to one or more knowledge graph triples.

At step 408, the automation module 112 causes the processing unit 202 to generate a first set of named graphs from the one or more knowledge graph triples. In other words, the automation module 112 causes the processing unit 202 to generate the first set of named graphs based on the analysis of the hardware configuration of the plurality of hardware equipment and the plurality of engineering objects in the plurality of engineering projects.

At step 410, the automation module 112 causes the processing unit 202 to encode the first set of named graphs to generate a first set of encoded data items by application of the autoencoder algorithm on the first set of named graphs.

At step 412, the automation module 112 further causes the processing unit 202 to decode the first set of encoded data items to generate the second set of named graph by application of the autoencoder algorithm on the first set of encoded data items.

At step 414, the automation module 112 further causes the processing unit 202 to compare each named graph of the first set of named graph with a specific named graph of the second set of named graph.

At step 416, the automation module 112 further causes the processing unit 202 to determine a plurality of reconstruction loss parameters based on the comparison. In other words, the automation module 112 further causes the processing unit 202 to determine the reconstruction loss parameter threshold by application of the autoencoder algorithm on the first set of named graphs.

At step 418, the automation module 112 uses the processing unit 202 to receive an engineering project from a user via the one or more client devices 120A-N. The engineering project comprises information associated with a set of hardware equipments 108A-N and a set of engineering objects of the engineering project. The engineering project further comprises information associated with a hardware configuration of the set of hardware equipment 108A-N. The information associated with the hardware configuration of the set of hardware equipment 108A-N and the set of engineering objects of the engineering project is coded as a first automation markup language script or the like.

At step 420, the automation module 112 further causes the processing unit 202 to analyze the first automation markup language script to detect a plurality of nodes in the first automation markup language script.

The automation module 112 further causes the processing unit 202 to generate the first named graph based on the analysis of the hardware configuration of the set of hardware equipment 108A-N and the set of engineering objects in the engineering project.

At step 422, the automation module 112 further causes the processing unit 202 to receive information about one or more modifications in the hardware configuration of the set of hardware equipment 108A-N in the engineering project. The second automation markup language script comprises information about hierarchical relationships between the set of hardware equipment 108A-N, after the modification of the hardware configuration of the set of hardware equipment 108AN.

At step 424, the automation module 112 further causes the processing unit 202 to analyze the first named graph, and the one or more modifications in the hardware configuration of the set of hardware equipment 108A-N. The automation module 112 further causes the processing unit 202 to generate a second named graph based on the analysis of the one or more modifications of the hardware configuration of the set of hardware equipment 108A-N.

At step 426, the automation module 112 further causes the processing unit 202 to determine a first hierarchical path between at least two nodes of the first named graph, and a second hierarchical path between corresponding nodes of the second named graph. The automation module 112 further causes the processing unit 202 to compare the determined first hierarchical path and the second hierarchical path.

At step 428, the automation module 112 further causes the processing unit 202 to determine the plurality of differences between the first named graph and the second named graph, based on the comparison. In one example, the plurality of differences are determined by the processing unit by use of a knowledge graph query process. The automation module 112 further causes the processing unit 202 to map the determined plurality of differences to one or more engineering objects of the plurality of engineering objects. The automation module 112 further causes the processing unit 202 to modify the one or more engineering objects of the plurality of engineering objects of the engineering project. The one or more engineering objects are modified based on the second named graph.

At step 430, the automation module 112 further causes the processing unit 202 to encode the second named graph to generate a second encoded data item by application of the autoencoder algorithm on the third named graph. In one example, the second encoded data item is a named graph comprising one or more entity embeddings which comprises information of the second named graph in an encoded format.

At step 432, the automation module 112 further causes the processing unit 202 to decode the second encoded data item to generate the third named graph by application of the autoencoder algorithm on the second encoded data item. The automation module 112 further causes the processing unit 202 to compare the third named graph with the second named graph.

At step 434, the automation module 112 further causes the processing unit 202 to determine a reconstruction loss parameter based on the comparison. In other words, the automation module 112 further causes the processing unit 202 to determine the reconstruction loss parameter by application of the autoencoder algorithm on the second named graph.

At step 436, the automation module 112 further causes the processing unit 202 to compare the reconstruction loss parameter with the reconstruction loss parameter threshold. In other words, the automation module 112 further causes the processing unit 202 to determine that the one or more modifications are invalid based on the comparison of the reconstruction loss parameter with the reconstruction loss parameter threshold.

At step 438, the automation module 112 further causes the processing unit 202 to generate a user alert based on the determination that the one or more modifications are invalid.

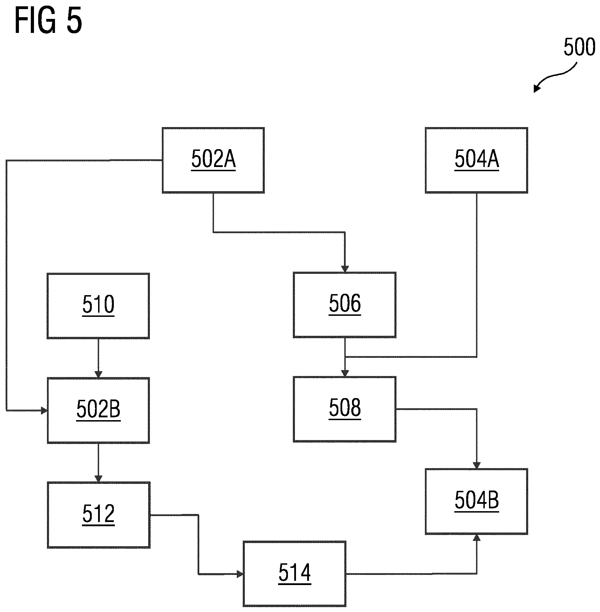

FIG 5 is a process flow diagram illustrating an exemplary method of monitoring modifications of a hardware configuration of a plurality of hardware equipment in an industrial plant, according to an embodiment of the present invention. FIG 5 is explained in conjunction with FIG 1, 2, 3, and 4A-D.

The process flow diagram 500 illustrates a first hardware configuration file 502A and a engineering project 504A. The engineering project 504A comprises a plurality of engineering objects configured to control the plurality of hardware equipment 108A-N in the industrial plant 106. The first hardware configuration file 502A comprises information about hardware configuration such as wiring aspects, power rating, voltage rating, and the like of each of the plurality of hardware equipment 108A-N in the industrial plant 106. The engineering project 504B comprises a plurality of engineering objects configured to control the plurality of hardware equipment 108A-N. The plurality of engineering objects comprises programming blocks, source codes, program files, and the like.

The first hardware configuration file 502A is converted by the processing unit 202, into the first automation markup language script 506. The processing unit 202 is further configured to generate a first named graph 508 from the engineering project and the first automation markup language script 506.

In one example, a user 510 may introduce one or more modifications 502B to the first hardware configuration file 502A. The processing unit 202 is further configured to convert the one or more modifications 502B into a second automation markup language script 512. The second automation markup language script is further converted by the processing unit 202 into a second named graph 514. At step 504B, the processing unit 202 is configured to determine a reconstruction loss parameter of the second named graph 514 and validate the received one or more modifications 502B.

The present invention can take a form of a computer program product comprising program modules accessible from computer-usable or computer-readable medium storing program code for use by or in connection with one or more computers, processing units, or instruction execution system. For the purpose of this description, a computer-usable or computer-readable medium can be any apparatus that can contain, store, communicate, propagate, or transport the program for use by or in connection with the instruction execution system, apparatus, or device. The medium can be electronic, magnetic, optical, electromagnetic, infrared, or semiconductor system (or apparatus or device) or a propagation mediums in and of themselves as signal carriers are not included in the definition of physical computer-readable medium include a semiconductor or solid state memory, magnetic tape, a removable computer diskette, random access memory (RAM), a read only memory (ROM), a rigid magnetic disk and optical disk such as compact disk read-only memory (CD-ROM), compact disk read/write, and DVD. Both processing units and program code for implementing each aspect of the technology can be centralized or distributed (or a combination thereof) as known to those skilled in the art.

While the present invention has been described in detail with reference to certain embodiments, it should be appreciated that the present invention is not limited to those embodiments. In view of the present disclosure, many modifications and variations would be present themselves, to those skilled in the art without departing from the scope of the various embodiments of the present invention, as described herein. The scope of the present invention is, therefore, indicated by the following claims rather than by the foregoing description. All changes, modifications, and variations coming within the meaning and range of equivalency of the claims are to be considered within their scope. All advantageous embodiments claimed in method claims may also be apply to system/apparatus claims.

### List of references

1. an industrial environment 100
2. an engineering system 102
3. one or more client devices 120A-N
4. a network 104
5. plurality of hardware equipment 108A-N
6. a platform 110
7. an automation module 112
8. a server 114
9. a network interface 116
10. a database 118
11. a processor(s) 202
12. an accessible memory 204
13. a storage unit 206
14. a communication interface 208
15. an input-output unit 210
16. a network interface 212
17. a bus 214
18. an integrated development environment (IDE) 216
19. a request handler module 302,
20. an ontology generation module 304,
21. an analysis module 306,
22. a modifier module 308
23. engineering project database 310
24. a validation module 312
25. a deployment module 314.

## Claims

1. A method for monitoring modifications of a hardware configuration of a plurality of hardware equipment in an industrial plant (106), the method comprising:
generating, by the processing unit (202), a first named graph (508) based on an analysis of a hardware configuration of a set of hardware equipment (108A-N) and a set of engineering objects in an engineering project (504A);
determining, by the processing unit (202), a reconstruction loss parameter threshold by application of an autoencoder algorithm on a plurality of named graphs associated with a plurality of engineering projects;
receiving from a user (510), by a processing unit (202), information about one or more modifications (502B) in the hardware configuration of the set of hardware equipment (108A-N) in the engineering project (504A) ;
generating, by the processing unit (202), a second named graph (514) based on an analysis of the first named graph (508) and the one or more modifications (502B) of the hardware configuration of the set of hardware equipment, wherein the second named graph (514) comprises information associated with a modified hardware configuration of the set of hardware equipment (108A-N) and the set of engineering objects;
determining, by the processing unit (202), a reconstruction loss parameter by application of an autoencoder algorithm on the second named graph (508);
determining, by the processing unit (202), that the one or more modifications are invalid based on a comparison of the reconstruction loss parameter with the reconstruction loss parameter threshold; and
outputting, by the processing unit (202), a user alert based on the determination that the one or more modifications are invalid.

2. The method according to claim 1, wherein
the engineering project (504A) is configured to automate the plurality of hardware equipment, and
the first named graph (508) comprises information about relationships between the hardware configuration of the set of hardware equipment (108A-N) and the set of engineering objects associated with the engineering project (504A);

3. The method according to claims 1 and 2, wherein the information (502A) about the hardware configuration of the set of hardware equipment (108A-N) is coded as a first automation markup language script (506).

4. The method according to claim 2, wherein generating the first named graph comprises:
analyzing, by the processing unit (202), the first automation markup language script (506) to detect a plurality of nodes in the first automation markup language script;
converting, by the processing unit (202), each of the plurality of nodes to one or more knowledge graph triples; and
generating, by the processing unit (202), the first named graph (508) from the one or more knowledge graph triples, wherein the first named graph (508) comprises a knowledge graph based semantic representation of hierarchical relationships between each of the plurality of nodes in the first automation markup language script (506) .

5. The method according to claims 1 to 4, wherein generating, the second named graph comprises:
converting, by the processing unit (202), the one or more modifications (502B) in the hardware configuration of the set of hardware equipment (108A-N) into a second automation markup language script (512);
generating, by the processing unit (202), a knowledge graph instance based on an analysis of the second automation markup language script (512);
integrating, by the processing unit (202), the knowledge graph instance into the first named graph (508); and
generating, by the processing unit (202), the second named graph (514) based on integration of the knowledge graph instance into the first named graph (508) .

6. The method according to claims 1 to 5, wherein determining, by the processing unit (202), the reconstruction loss parameter threshold comprises:
encoding, by the processing unit (202), each of the first set of named graphs to generate a set of encoded data items by application of the autoencoder algorithm on the first named graph (508);
decoding, by the processing unit (202), the set of encoded data items to generate a second set of named graph by application of the autoencoder algorithm on the set of encoded data items;
comparing, by the processing unit (202), each named graph of the first set of named graphs with a specific named graph of the second set of named graphs; and
determining, by the processing unit (202), the reconstruction loss parameter threshold based on the comparison of each named graph of the first set of named graphs with the specific named graph of the second set of named graphs.

7. The method according to claims 1 to 6, wherein determining, by the processing unit (202), the reconstruction loss parameter comprises:
encoding, by the processing unit (202), the second named graph (514) to generate an encoded data item by application of the autoencoder algorithm on the second named graph (514);
decoding, by the processing unit (202), the encoded data item to generate a third named graph by application of the autoencoder algorithm on the encoded data item;
comparing, by the processing unit (202), the second named graph (514) and the third named graph; and
determining, by the processing unit (202), the reconstruction loss parameter threshold based on the comparison.

8. The method according to claims 1 to 3, further comprising:
determining, by the processing unit (202), a plurality of differences between the first named graph (508) and the second named graph (514); and
mapping, by the processing unit (202), the determined plurality of differences to one or more engineering objects of the plurality of engineering objects.

9. The method according to claim 8, wherein determining the plurality of differences between the first named graph (508) and the second named graph (514) comprises:
determining, by the processing unit (202), a first hierarchical path between at least two nodes of the first named graph, and a second hierarchical path between corresponding nodes of the second named graph;
comparing, by the processing unit (202), the determined first hierarchical path and the second hierarchical path; and
determining, by the processing unit (202), the plurality of differences between the first named graph (508) and the second named graph (514) based on comparison.

10. The method according to any of the claims 8 and 9, further comprising:
generating, by the processing unit (202), a voice based recommendation by application of a natural language processing algorithm on the generated user alert.

11. The method according to claim 8 to 10, further comprising:
generating, by the processing unit (202), a simulation instance for an industrial environment (100); and
simulating, by the processing unit (202), deployment of the modified engineering project in the industrial environment (100) by executing one or more functionalities of the engineering project on the generated simulation instance.

12. An engineering system (102) for monitoring modifications of a hardware configuration of a plurality of hardware equipment in an industrial plant (106), wherein the engineering system comprises:
one or more processing unit(s) (202); and
a memory (204) coupled to the one or more processing unit(s), wherein the memory comprises an automation module (112) stored in the form of machine-readable instructions executable by the one or more processing unit(s), wherein the automation module (112) is capable of performing a method according to any of the claims 1-11.

13. An industrial environment (100) comprising:
an engineering system (102) as claimed in claim 12;
an industrial plant (106) comprising one or more physical components; and
one or more client devices (120A-N) communicatively coupled to the engineering system (102) via a network (104), wherein the engineering system (102) is configured to perform a method according to any of the claims 1 to 11.

14. A computer-program product, having machine-readable instructions stored therein, that when executed by one or more processing unit(s) (202), cause the processing units to perform a method according to any of the claims 1-11.
